# EUROPEAN PATENT APPLICATION

(11) **EP 1 783 896 A2**
(43) Date of publication of application: **09.05.2007**
(21) Application number: 06123459.7
(22) Date of filing: 03.11.2006
(51) Int. Cl.: H03F 1/30, H03F 1/32, H03F 3/24, H03F 3/189

(54) **Apparatus for optimizing gate bias of radio frequency amplifier and method thereof**

(30) Priority: 04.11.2005 KR 20050105499
(71) Applicant: Samsung Electronics Co., Ltd., Suwon-si, Gyeonggi-Do (KR)
(72) Inventor: Lee, Jong-Sung, Yongin-si, Gyeonggi-do (KR)
(74) Representative: Grünecker, Kinkeldey, Stockmair & Schwanhäusser Anwaltssozietät

(57) **Abstract**

Disclosed is an apparatus for maintaining the linearity of a Radio Frequency amplifier that includes a coupler (203) for coupling a signal input to a power amplifier (201), a gate bias controller (205) for determining a gate bias voltage in accordance with the signal level, and a power amplifier (201) for amplifying the input signal with the input signal maintained using the gate bias voltage received from the gate bias controller (205), making possible improved linearity of power amplifier output in an entire output region and increased Inter Modulation Distortion (IMD) cancellation when a pre-distorter is used. Since the linearity characteristic of the power amplifier is optimized despite reduction in output signal level of the power amplifier, it is possible to use one power amplifier for a single Frequency Allocation (FA) condition of a high output and a multi FA condition of a low output.

## Description

### PRIORITY

This application claims priority under 35 U.S.C. § 119 to an application filed in the Korean Intellectual Property Office on November 4, 2005 and assigned Serial No. 2005-105499, the contents of which are incorporated herein by reference.

### BACKGROUND OF THE INVENTION

### 1. Field of the Invention

The present invention relates generally to an apparatus for improving the efficiency of a power amplifier and a method thereof, and in particular, to an apparatus for adaptively supplying an optimal gate bias voltage in accordance with the level of the input signal of a power amplifier and a method thereof.

### 2. Description of the Related Art

In general, a power amplifier is used for amplifying the power of an input signal to increase the power of an output signal. It is ideal to linearly increase only the magnitude of the signal. However, the power amplifier includes a plurality of active components. The output signal of the power amplifier is distorted due to non-linear characteristics of the active components that constitute the power amplifier.

Amplification of a plurality of carriers or use of a wireless transmitter in a digital modulation system having excellent frequency efficiency in a mobile communication system causes Inter Modulation Distortion (IMD) generated by the non-linear characteristic of the power amplifier to deteriorate the performance of the system.

Therefore, in order to compensate for non-linearity of the power amplifier, a uniform gate bias voltage is applied to the power amplifier so that the linearity of the signal input to the power amplifier is optimized.

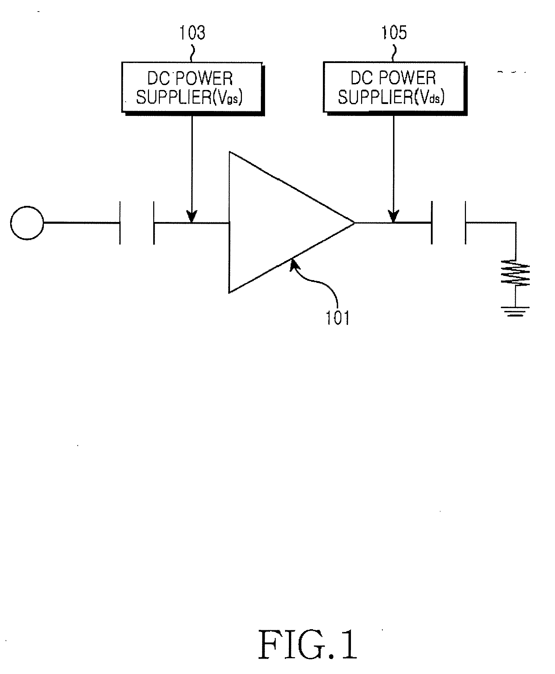

FIG 1 illustrates the structure of a conventional Radio Frequency (RF) power amplifier. As illustrated in FIG 1, the power amplifier 101 linearly amplifies the input signal using the gate bias voltage received from a Direct Current (DC) power supplier 103. That is, the power amplifier 101 compensates for the non-linearity of the power amplifier 101 using the gate bias received from the DC power supplier 103.

As described above, the gate bias voltage is provided to the power amplifier to compensate for the non-linearity of the power amplifier. However, the gate bias voltage used for compensating for the non-linearity of the power amplifier compensates for only the non-linearity of the level of a specific signal. Therefore, when the average power of the signal input to the power amplifier changes, the characteristic of the power amplifier changes so that it is not possible to obtain an optimal effect. For example, when a communication system that uses a narrow band single carrier power amplifier requires a multi carrier power amplifier whose output level is reduced (for example, a smart antenna), the power amplifier must be exchanged.

### SUMMARY OF THE INVENTION

An object of the present invention is to substantially solve at least the above problems and/or disadvantages and to provide at least the advantages below. Accordingly, the present invention provides an apparatus for providing an adaptive gate bias voltage in accordance with the level of the input signal of a power amplifier and a method thereof.

Another object of the present invention is to provide an apparatus for adaptively providing a gate bias voltage in accordance with the level of the input signal of a power amplifier to implement the power amplifier of single carrier and the power amplifier of multi carrier in one power amplifier and a method thereof.

To achieve the above objects, the present invention provides a power amplifying apparatus includes a coupler for coupling a signal input to a power amplifier, a gate bias controller for determining a level of the coupled signal to determine a gate bias voltage in accordance with the level of the signal, and a power amplifier for amplifying the input signal using the gate bias voltage received from the gate bias controller.

According to the present invention, a method of maintaining the linearity of a power amplifier includes coupling a signal input to the power amplifier to determine the level of the signal, determining a gate bias voltage in accordance with the level of the input signal, and amplifying the input signal with the linearity of the input signal maintained using the gate bias voltage.

According to the present invention, a power amplifying apparatus of a base station in a mobile communication system includes a coupler for coupling a signal input to a power amplifier, a gate bias controller for determining the level of the coupled signal to determine a gate bias voltage in accordance with the level of the signal, and a power amplifier for amplifying the input signal using the gate bias voltage received from the gate bias controller.

According to the present invention, a method of amplifying an output signal in the base station of a mobile communication system includes coupling the output signal to determine the level of the coupled signal, determining a gate bias voltage in accordance with the level of the output signal, and amplifying the output signal with the linearity of the output signal maintained using the gate bias voltage.

### BRIEF DESCRIPTION OF THE DRAWINGS

The above and other objects, features and advantages of the present invention will become more apparent from the following detailed description when taken in conjunction with the accompanying drawings in which:
FIG. 1 illustrates the structure of a conventional RF power amplifier;
FIG 2 illustrates the structure of a RF power amplifier according to the present invention;
FIG 3 illustrates the detailed structure of a gate bias controller according to the present invention;
FIG 4 is a flowchart of the process of optimizing a gate bias voltage in the RF power amplifier according to the present invention;
FIGs. 5A to 5C are graphs illustrating the adjacent channel leakage power ratio (ACLR) characteristic of the RF power amplifier;
FIG 6 is a graph illustrating changes in the gate bias voltage of the RF power amplifier according to the present invention; and
FIG 7 is a graph illustrating changes in the current consumption of the RF power amplifier corresponding to the levels of the input signals of the power amplifier according to the present invention.

### DETAILED DESCRIPTION OF THE PREFERRED EMBODIMENTS

Preferred embodiments of the present invention will be described herein below with reference to the accompanying drawings. In the following description, well-known functions or constructions are not described in detail since they would obscure the invention in unnecessary detail.

The present invention provides a technique for adaptively changing a gate bias voltage in accordance with the level of the input signal of a power amplifier to compensate for the non-linearity of an amplified signal. Hereinafter, a Radio Frequency (RF) power amplifier for amplifying an RF signal in a base station will be taken as an example. Here, since the power amplifier is used for amplifying the output signal of the base station, the input signal of the power amplifier means the output signal of the base station.

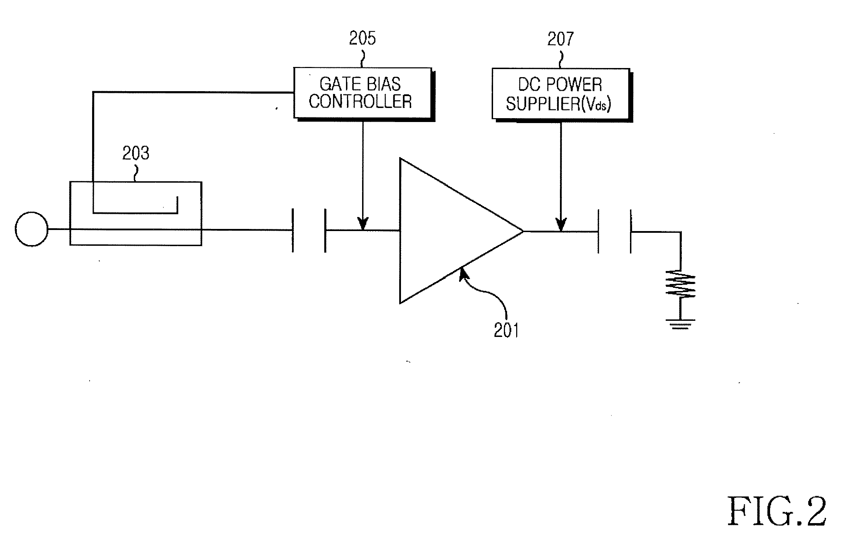

FIG 2 illustrates the structure of an RF power amplifier according to the present invention. As illustrated in FIG 2, the RF power amplifier includes a power amplifier 201, a coupler 203, a gate bias controller 205, and a direct current (DC) power supplier 207.

The coupler 203 couples the RF input signal input to the power amplifier 201 to output the coupled RF input signal to the gate bias controller 205. The gate bias controller 205 selects a gate bias voltage for maintaining the optimal linearity of the RF signal coupled by the coupler 203 to provide the selected gate bias voltage to the power amplifier 201. Here, the gate bias controller 205 includes a predetermined gate bias voltage table to select the gate bias voltage corresponding to the input RF signal from the gate bias voltage table.

The power amplifier 201 linearly amplifies the input RF signal using the gate bias voltage received from the gate bias controller 205 to output the linearly amplified RF signal.

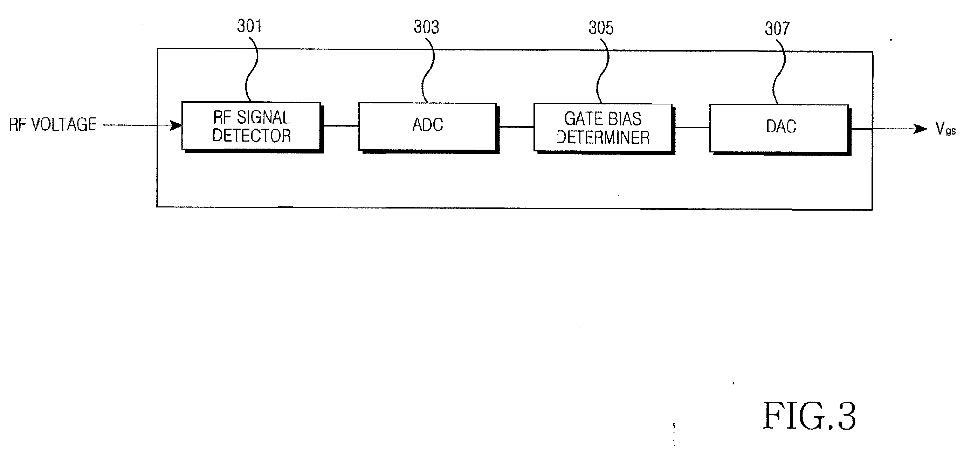

The gate bias controller 205 for selecting the gate bias voltage corresponding to the RF signal in FIG 2 preferably has the structure illustrated in FIG 3. FIG 3 illustrates the detailed structure of the gate bias controller according to the present invention. As illustrated in FIG 3, the gate bias controller 205 includes an RF signal detector 301, an analog/digital converter 303, a gate bias determiner 305, and a digital/analog converter 307.

The RF signal detector 301 receives the RF signal coupled by the coupler 203 to detect the voltage of the RF signal. The analog/digital converter 303 converts the analog signal for the voltage of the RF signal that is received from the RF signal detector 301 into a digital signal to output the digital signal.

The gate bias determiner 305 determines the gate bias voltage provided to the power amplifier 201 using the signal received from the analog/digital converter 303. At this time, the gate bias determiner 305 includes the gate bias voltage table that includes gate bias voltages corresponding to the levels (voltages) of the RF signals to amplify the RF signal with the linearity of the RF signal maintained. Therefore, the gate bias determiner 305 determines the gate bias voltage corresponding to the level (voltage) of the RF signal detected by the RF signal detector 301 from the gate bias voltage table to output the gate bias voltage. Here, the gate bias voltage table includes the optimal gate bias voltage determined by experiments corresponding to varied input signal levels so that the linearity of the power amplifier is maintained.

The digital/analog converter 307 converts the digital output signal corresponding to the gate bias voltage received from the gate bias determiner 305 into an analog signal to provide the analog signal to the power amplifier 201.

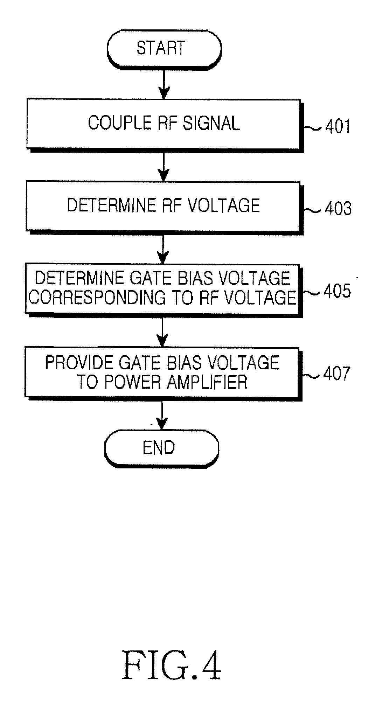

FIG. 4 is a flowchart of the process of optimizing a gate bias voltage in the RF power amplifier according to the present invention. Referring to FIG 4, first, the RF power amplifier couples the RF signal input to the power amplifier 201 using the coupler 203, in a step 401. Then, the process proceeds to a step 403 in which the RF power amplifier determines the voltage of the RF signal coupled by the RF signal detector 301.

After determining the voltage of the RF signal, the algorithm proceeds to a step 405 in which the RF power amplifier selects the gate bias voltage corresponding to the determined RF signal from a predetermined gate bias voltage table. Here, the gate bias voltage table includes the optimal gate bias value determined by experiments corresponding to varied input signal levels so that the linearity of the power amplifier is maintained.

Then, the process proceeds to a step 407 in which the RF power amplifier provides the selected gate bias voltage to the power amplifier 201 to amplify the input RF signal with the linearity of the RF signal maintained. Then, the process is terminated.

As described above, the power amplifier controls the gate bias voltage in accordance with the level of the signal input to the power amplifier to linearly amplify the signal. Therefore, the gate bias voltage of one power amplifier is controlled to use as the single carrier power amplifier and the multi carrier power amplifier as well.

FIGs. 5A to 5C are graphs illustrating an Adjacent Channel Leakage power Ratio (ACLR) characteristic of the RF power amplifier. Hereinafter, the abscissa represents the power (dBm) of the input RF signal and the ordinate represents an Adjacent Channel Leakage power Ratio (hereinafter, referred to as ACLR) (-dBr). Hereinafter, a difference in the ACLR characteristic between conventional systems and the present invention in -4.77MHz offset and +4.77MHz offset based on one frequency allocation is illustrated.

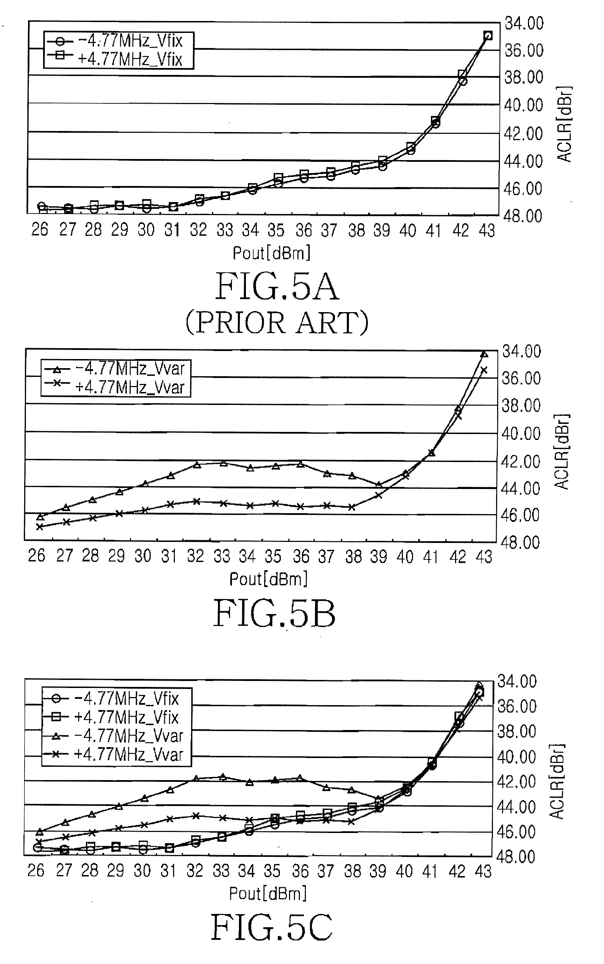

FIG 5A is a graph illustrating the ACLR characteristic of the conventional RF power amplifier. FIG 5B is a graph illustrating the ACLR characteristic of the RF power amplifier according to the present invention. FIG 5C is a graph comparing the ACLR characteristic of the conventional RF power amplifier and the ACLR characteristic of the RF power amplifier according to the present invention with each other.

As illustrated in FIG 5A, the ACLR characteristic of the conventional power amplifier is optimized in about 41 dBm. However, the spectrum delta marker values of the ±4.77MHz offsets do not coincide with each other in no more than the optimal level (no more than about 40dBm). That is, the ACLR of the power amplifier is imbalanced. An imbalance of the ACLR of the power amplifier means that memory effect exists so that the ACLR may deteriorate according as an output level changes. Here, the memory effect means that a secondary harmonic component in the frequency allocation among the Inter Modulation Distortion (hereinafter referred to as IMD) harmonic components generated by modulation frequency affects an operating frequency allocation again so that the IMD is imbalanced in respect of frequency.

On the other hand, as illustrated in FIG. 5B, a gate bias is controlled in accordance with the level of the RF signal input from the power amplifier according to the present invention so that the ACLR characteristics of the ±4.77MHz offsets of the entire region coincide with each other. Therefore, the power amplifier can amplify the signal without distortion although the level of the input signal changes.

Also, as illustrated in FIG. 5C, the ACLR characteristic of the conventional power amplifier entirely deteriorates in comparison with the ACLR characteristic of the power amplifier according to the present invention no more than a predetermined level (no more than about 41 dBm).

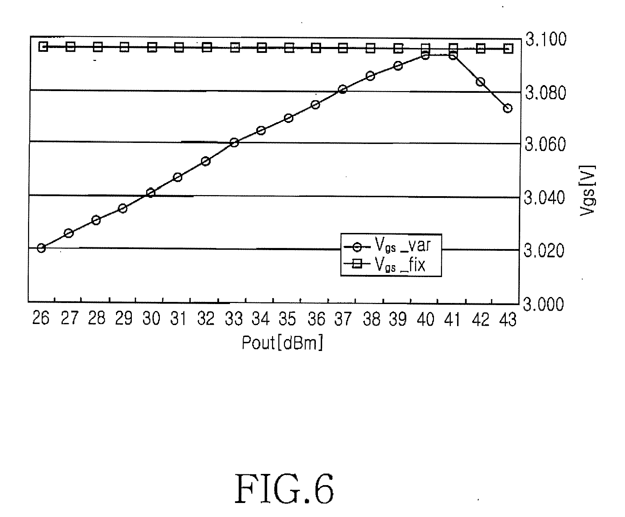

FIG 6 is a graph illustrating changes in the gate bias voltage of the RF power amplifier according to the present invention. Hereinafter, the abscissa represents the power (dBm) of an input RF signal and the ordinate represents a gate bias voltage (V_{gs}).

As illustrated in FIG 6, while the gate bias voltage provided to the conventional power amplifier is uniform in an entire region, the gate bias voltage provided to the power amplifier according to the present invention changes in accordance with a change in the level of the signal input to the power amplifier. Here, the gate bias voltage corresponding to the level of the input signal of the power amplifier is predetermined by experiments.

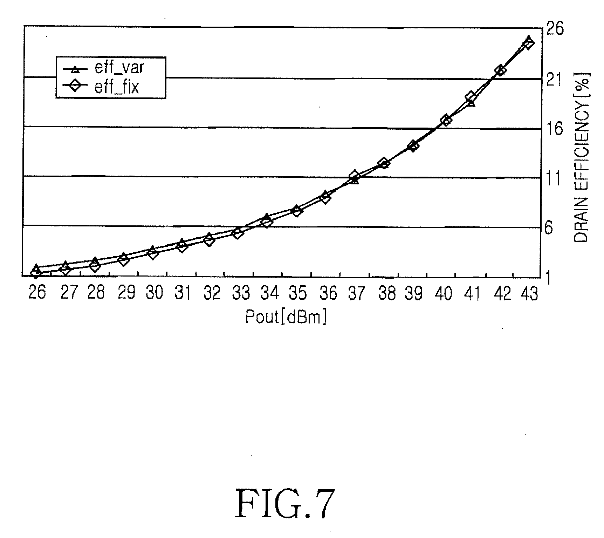

FIG 7 is a graph illustrating changes in the current consumption of the RF power amplifier corresponding to the levels of the input signals of the power amplifier according to the present invention. Hereinafter, the abscissa represents the power (dBm) of an input RF signal and the ordinate represents drain efficiency.

It is noted from FIG 7, in which the efficiency characteristic of the power amplifier corresponding to the level of the input signal of the power amplifier is illustrated, that changes in efficiency are small since changes in current consumption are small in the conventional art and according to the present invention.

As described above, it is possible to improve the linearity characteristic of the power amplifier in the entire output region by adaptively changing the gate bias voltage in accordance with the level of the input signal to apply the changed gate bias voltage and to increase the amount of IMD cancellation when a pre-distorter is used by preventing the IMD from being imbalanced. Also, since the linearity characteristic of the power amplifier is always optimized although the level of the input signal of the power amplifier is reduced, it is possible to use one power amplifier for a single frequency allocation (FA) condition of a high output and a multi FA condition of a low output.

While the invention has been shown and described with reference to certain preferred embodiments thereof, it will be understood by those skilled in the art that various changes in form and details may be made therein without departing from the spirit and scope of the invention as defined by the appended claims.

## Claims

1. A power amplifying apparatus, comprising:
a coupler for coupling an input signal;
a gate bias controller for determining a level of the coupled signal to determine a gate bias voltage; and
a power amplifier for amplifying the input signal using the gate bias voltage received from the gate bias controller.

2. The power amplifying apparatus of claim 1, wherein the gate bias controller comprises:
a signal detector for determining the level of the coupled signal; and
a gate bias determiner for determining a gate bias voltage in accordance with the determined level of the coupled signal.

3. The power amplifying apparatus of claim 2, wherein the gate bias determiner comprises a gate bias voltage table including gate bias voltage information corresponding to levels of input signals to select the gate bias voltage corresponding to the level of the coupled signal determined by the signal detector from the gate bias voltage table.

4. The power amplifying apparatus of claim 3, wherein the gate bias voltage table includes gate bias voltage data determined by experiments corresponding to varied input signal levels.

5. A method of maintaining power amplifier linearity, the method comprising the steps of:
coupling an input signal to the power amplifier to determine a level of the input signal;
determining a gate bias voltage in accordance with the level of the input signal; and
amplifying the input signal using the gate bias voltage while maintaining linearity of the input signal.

6. The method of claim 5, wherein the step of determining the gate bias voltage comprises selecting the gate bias voltage corresponding to the level of the input signal from a gate bias voltage table that includes gate bias voltage information corresponding to levels of input signals.

7. The method of claim 6, wherein the gate bias voltage table includes gate bias voltages determined by experiments corresponding varied input signal levels.

8. A power amplifying apparatus of a base station in a mobile communication system, comprising:
a coupler for coupling an input signal to a power amplifier;
a gate bias controller for determining a level of the coupled signal to determine a gate bias voltage in accordance with the level of the signal; and
a power amplifier for amplifying the input signal using the gate bias voltage received from the gate bias controller.

9. The power amplifying apparatus of claim 8, wherein the gate bias controller comprises:
a signal detector for determining the level of the coupled signal; and
a gate bias determiner for determining a gate bias voltage in accordance with the determined level of the signal.

10. The power amplifying apparatus of claim 9, wherein the gate bias determiner comprises a gate bias voltage table including gate bias voltage information corresponding to levels of input signals to select the gate bias voltage corresponding to the level of the coupled signal determined by the signal detector from the gate bias voltage table.

11. The power amplifying apparatus of claim 10, wherein the gate bias voltage table includes gate bias voltage data determined by experiments corresponding to varied input signal levels.

12. A method of amplifying an output signal in a base station of a mobile communication system, the method comprising the steps of:
coupling the output signal to determine a level of a coupled signal;
determining a gate bias voltage in accordance with the level of the coupled signal; and
amplifying the output signal using the gate bias voltage while maintaining linearity of the output signal.

13. The method of claim 12, wherein the step of determining the gate bias voltage comprises selecting the gate bias voltage corresponding to the level of the input signal from a gate bias voltage table that includes gate bias voltage information items corresponding to levels of the output signals.

14. The method of claim 13, wherein the gate bias voltage table includes gate bias voltage data determined by experiments corresponding to varied output signal levels.
